(19) Europäisches Patentamt
European Patent Office
Office européen des brevets

(11) Publication number: 0 285 025 A2

# (12) EUROPEAN PATENT APPLICATION

(21) Application number: 88104834.2

(51) Int. Cl.4: G03F 7/10

(22) Date of filing: 25.03.88

(30) Priority: 30.03.87 US 32420

(43) Date of publication of application: 05.10.88 Bulletin 88/40

(84) Designated Contracting States: DE FR GB IT

(71) Applicant: SHIPLEY COMPANY INC.
2300 Washington Street
Newton, Massachusetts 02162(US)

(72) Inventor: Cunningham, Wells Crassous
62 Walnut Street
Wellesley Massachussetts 02181(US)

(74) Representative: Bunke, Holger, Dr.rer.nat. Dipl.-Chem. et al
Patentanwälte Prinz, Leiser, Bunke & Partner
Manzingerweg 7
D-8000 München 60(DE)

## (54) Silylated poly(vinyl)phenol resists.

(57) Both positive and negative acting photoresist compositions are provided which contain one or more silylated poly(vinyl)phenol polymers and at least one sensitizer which forms an acid upon irradiation. The anion of such acids has an affinity for silicon.

EP 0 285 025 A2

Xerox Copy Centre

# SILYLATED POLY(VINYL)PHENOL RESISTS

## BACKGROUND OF THE INVENTION

This invention relates to photoresist compositions and the use thereof in the fabrication of devices used in the electronics industry and in particular to fabrication utilizing lithographic processes. More particularly, this invention relates to photoresist compositions comprising a silylated poly(vinyl)phenol polymer and at least one sensitizer which forms an acid when irradiated.

Photolithography is a commonly used technique in transposing a pattern to a base which utilizes a radiation-sensitive polymer generally referred to as photoresist. Liquid photoresists coating compositions are used to form liquid coatings from organic solutions which, when dried and exposed to light of the proper wavelength, e.g., u.v. or visible light, x-ray, e-beam, are chemically changed in their solubility to certain solvents or developers. Exposure is made through a film pattern or master.

Two types of resists are available: negative-acting and positive-acting. Depending upon the chemical nature of the resist material, the exposed areas may be rendered more soluble in some developing solvents than the unexposed areas, thereby producing a positive tone image of the mask, i.e., a positive acting resist. Conversely the exposed areas may be rendered less souble producing a negative tone image of the mask, i.e., a negative acting resist. The net effect of this process is to produce a three dimensional relief image in the resist material that is a replication of the opaque and transparent areas on the mask. In the semiconductor industry it is sometimes preferred to use positive acting resists, especially at smaller geometrics.

The areas of resist that remain following the imaging and developing processes (and post baking in some cases) are used to mask the underlying substrate for subsequent etching or other image transfer steps. If, for example, the underlying substrate or base were $SiO_2$, immersion of the structure into an etchant such as buffered hydrofluoric acid ("wet etching") or in an organo-halide plasma or other reactive ion etching ("RIE") medium, would result in selective etching of the $SiO_2$ in those areas that were bared during the development step. The resist material "resists" the etchant and prevents it from attacking the underlying substrate in those areas where it remains in place after development. After the exposed material has been removed by plasma or wet chemical etching, the photoresist mask is generally taken off.

Monolayer and multi-layer resist (MLR) systems have been developed. In monolayer systems the resist is applied in a thin layer directly to the substrate. Such systems may be used in the formation of, e.g., electronic devices, ion implant masks, or patternable oxide layers for subsequent metal etching.

Many multilayer concepts have emerged all of which have in common the generation of an image in a thin layer of resist followed by transfer of the image into a thicker, planarizing underlying film. Image transfer into the planarizing layer may be accomplished by deep u.v. light exposure as in the conformable mask method, or by plasma or other RIE. Plasma etching is the etching of a material by reaction with chemically active gaseous species formed by glow discharge. Procedures for plasma etching are known and described in the literature, for example, Paulsen, Plasma Etching in Integrated Circuit Manufacture, J. Vac. Sci. Technol., Vol. 14, No. 1. Jan./Feb. 1977, pp 266 to 274. See, e.g., Introduction to Microlithography, Chapter 6, Lin, B. J., Thompson, L.F. et al., Eds., ACS Symposium Series 219, Washington, D.C., 1983.

In preparing MLR's a thick resist layer is first applied over topography, to provide a planar surface upon which a thin imaging resist layer can coat uniformly. After the imaging layer is delineated, it is used as a blanket exposure mask or etch mask to delineate the planarizing layer. Many times, a third layer is used between the imaging and the planarizing layers as the PCM. This becomes a three-layer system in which the imaging and masking functions of the top layer are now separated. For special applications, more than three layers may be required. The thickness of the planarizing layer is usually between 1 and 4 $\mu m$, depending on the wafer topography and other considerations. The thickness of the imaging layer and the isolation layer is usually about 0.3 - 0.5 $\mu m$ and 0.05 - 0.2 $\mu m$ respectively. Resists are utilized in the formation of electronic devices and bi-layer and tri-layer are especially suitable for the lithographic definition of small features, i.e., features smaller than 1 $\mu m$. See, e.g., U.S. 4, 481, 049; Lynn, B. J., et al., J. Vac. Sci. Technol., 1981, 19 Page 1313; Tai, K. L., et al., J. Vac. Sci. Technol., 1979, 16 Page 1977.

Photoresists are used in the fabrication of semiconductors. The photoresist is coated onto the surface of a semiconductor wafer and then imaged and developed. Following development, the wafer is typically etched with an etchant whereby the portions of the wafer exposed by development of the photoresist are dissolved while the portions of the wafer coated with photoresist are protected, thereby defining a circuit pattern.

Once the imaging layer has been patterned, it is necessary, if a planarizing layer has been used, to transfer the pattern through the planarizing layer to the substrate. A current trend in the semi-conductor industry is to use dry-etching techniques to transfer the pattern through the planarizing layer. This is because conventional wet processes, which utilize solvent to transfer the pattern in the imaging layer through the planarizing layer, do not provide the anisotropic removal mechanism considered necessary to achieve optimal.dimensional control within the parameters of today's systems. Other reasons for dry etching include the generation of less solvent waste and less particulate contamination.

Photoresist compositions are well known in the art and are described in numerous publications including DeForest, Photoresist Materials and Processes, McGraw Hill Book Company, New York, 1975; Introduction to Microlithography, supra, Chap. 3, Willson, C.G. Resist materials can be classified as positive or negative on the basis of their radiation response as described above.

The positive-working resists comprise a radiation sensitive compound in a film-forming polymer binder. The radiation sensitive compounds, or sensitizers as they are often called, most frequently used where the radiation is light are esters and amides formed from o-quinone diazide sulfonic and carboxylic acids. These esters and amides are well known in the art and are described by DeForest, supra, pages 47-55, incorporated herein by reference. These light sensitive compounds, and the methods used to make the same, are all well documented in prior patents including German Pat. No. 865,140 granted Feb. 2, 1953 and U.S. Pat. Nos. 2,767,092; 3,046,110; 3,046,112; 3,046,119; 3,046,121; 3,046,122 and 3,106,465, all incorporated herein by reference. Additional sulfonic amide sensitizers that have been used in the formulation of positive-acting photoresists are shown in U.S. Pat. No. 3,637,384, also incorporated herein by reference. These materials are formed by the reaction of a suitable diazide of an aromatic sulfonyl chloride with an appropriate resin amine. Methods for the manufacture of these sensitizers and examples of the same are shown in U.S. Pat. No. 2,797,213 incorporated herein by reference. Other positive-working diazo compounds have been used for specific purposes. For example, a diazo compound used as a positive-working photoresist for deep U.V. lithography is Meldrum's diazo and its analogs as described by Clecak, et al., Technical Disclosure Bulletin, Volume 24, Number 4, September 1981, IBM Corporation, pp. 1907 and 1908. An o-quinone diazide compound suitable for laser imaging is shown in U.S. Pat. No. 4,207,107, which is also incorporated herein by reference.

Shipley's Microposit is a positive acting photoresist system, consisting of a novolak resin matrix material and a diazonaphthoquinone sensitizer. The matrix material is essentially inert to imaging photochemistry and chosen for its film-forming, adhesion, chemical and thermal resistance characteristics. The chemistry of the resist action occurs primarily in the sensitizer molecule, the diazonaphthoquinone.

Sensitizers which form a strong acid upon irradiation are known in the art. In Introduction to Microlithography, supra, pp. 153-154, Ito and co-workers describe a deep u.v. resist formulation which contains a poly(vinyl)phenol polymer and an onium salt sensitizer such as diphenyliodonium hexafluoroarsenate. Upon irradiation the sensitizer undergoes radiolysis to produce a local concentration of an inorganic acid. The acid reacts with the polymer side-chain, and acts as a catalyst for acidolysis of a group on the polymer. Development of the exposed resist in nonpolar solvents selectively removes unreacted resist to give a negative tone image. Development with a polar solvent (or aqueous base) selectively dissolves the exposed area and provides positive tone images. See also U.S. Patent Nos. 4,189,323 and 4,506,003 for additional examples.

Resists used in processing involving oxygen-RIE pattern transfer must have high oxygen-RIE resistivity. To meet this requirement silicon containing resists have been widely studied. In general, the etch rate of organosilicon polymers in an oxygen plasma is dependent only on the silicon content. See, a.g., Materials for Microlithography, Thompson, L.F., et al., eds., A.C.S. Symposium Series 266, Chap. 15, 1984.

One class of u.v. sensitive, oxygen RIE resistant silicon containing polymers used in bilayer processes is the polysiloxanes (See, e.g., Hatzakis, M. J., J. Vac. Sci. Technol., 26 (1979) 2984). These materials can function both as negative resists and oxygen RIE barriers.

Other silicon containing photoresists are known in the art. For example, Saotome, Y., et al., J. Electro Chem. Soc.: Solid-State Sci. and Tech., 132 (1985) 909, disclose a silicon containing positive photoresist as the thin top or resolution layer in a bi-layer resist system. This photoresist, a partly trimethylsilylmethylated resorcinol-formaldehyde resin mixed with a naphthoquinonediazide, was thinly coated onto a thick layer of polyimide resin on a silicon wafer. See also U.S. Patent No. 4,624,909.

Kawazu, R., et al., J. Vac. Sci. Technol. B4(1) (Jan./Feb. 1986) 409, disclosed tri-level and bi-level resist systems using silyl ethers of Novolak and low molecular weight resist. U.S. Patent No. 4,564,576 teaches a polymer having allyl groups each attached to a silicon atom as a resist material.

A silicon based negative resist is available from Toyo Soda Manufacturing Company, Ltd. ("TSK"), 4560 Tonda Shinnanyo-shi Yamaguchi-kan, Japan. According to TSK, this resist is a negative e-beam, x-ray and

deep u.v. resist for two-layer technology. It is developed with an organic solvent.

European Patent Application 0 195 291 discloses a method where an etch resistant patterned layer is obtained by creating reactive functional groups in areas of exposure and then treating them with an organo metallic reagent, such as a halosilane or hexamethyl disalazane. The pattern is subsequently transferred through non-exposed bottom polymeric layers using an oxygen plasma or equivalent dry etch method. Although this method provides either positive or negative tone patterns, it suffers the disadvantages of being highly dependent on the conditions of reaction with the organometallic compound. Vapors of these compounds are passed over the wafer and the exposed areas must react to the exclusion of the unexposed areas. Time of reaction, temperature, gas flow and reagent type are some of the variables. In addition, the unexposed areas may also react, which would cause contamination in the spaces after etching. Most importantly, this process adds the steps of an extra exposure and then reaction to an already complicated multi-level scheme.

European Patent Application 0 197 286 discloses a dry development method for a resist film. A negative type e-beam sensitive resist is disclosed. The resist film is selectively exposed to an electron beam to form a latent image of a desired pattern therein and, then, subjected to an irradiation of deep u.v. in air generating gas. The method described has the disadvantages of requiring long development times and reliance on a series of reactions subject to atmospheric conditions.

A positive optical resist for bilayer resist systems comprising essentially 100% silylated poly(vinyl)-phenol polymers was disclosed by Buiguez, F., et al. at the Micro Circuits Engineering Conference in Berlin in 1984 by a Poster Paper presented on behalf of Commissariat a l'Energie Atomique, France. See also EPO 0 178 208. The polymers used in making these resists are produced by first silylating vinyl phenol and then polymerizing the silylated phenol by a free radical polymerization process. The resists contain at least one inorganic salt capable of being converted into a Brunsted acid upon appropriate irradiation and one photosensitizer. According to these workers, the resist can be developed and the substrate simultaneously etched by dry processing with a gaseous plasma. It is believed that the metallic acid precurers and dopant species used by these workers may interfere with the quality of plasma development attainable. In addition, it is likely that the dopant species in the photoactive salts remain in the unexposed resist creating the serious potential for contamination in future processing steps.

Methods of making electronic devices using photoresist compositions known in the art suffer from various disadvantages such as: 1) non-aqueous development; 2) additional complexities, i.e., reactions with vapors, extra processing steps; 3) inorganic contamination; and 4) low contrast.

## SUMMARY OF THE INVENTION

The subject invention is directed to photoresist compositions and the use thereof in the fabrication of devices used in the electronics industry and in particular to fabrication utilizing lithographic processes. More particularly, this invention relates to photoresist compositions comprising an admixture of a silylated polymer and at least one acid forming sensitizer, the sensitizer comprising a non-metallic organic compound which forms an acid upon irradiation, and the use thereof in the fabrication of such devices. Both positive-acting and negative-acting photoresists are provided in accordance with the present invention.

In some embodiments of this invention, it may be desirable to admix a second sensitizer with the photoresist compositions and in other embodiments to incorporate a second sensitizer directly into the structure of the polymer itself.

The present invention also includes compositions and processees for forming oxide dielectric layers and photoresists for metal etching.

Silylated poly(vinyl)phenol polymers having a molecular weight range from about 2,700 to 22,000 and a percent by weight silicon of about 3% to 12% are useful in preparing photoresist compositions and practicing processes, in accordance with the present invention.

## DETAILED DESCRIPTION OF THE INVENTION

Photoresist compositions in accordance with the present invention comprise one or more silylated poly-(vinyl)phenol polymers and at least one acid forming sensitizer, the first sensitizer comprising a non-metallic organic compound which forms an acid upon irradiation, wherein the anion of the acid has an affinity for silicon. Preferred species are characterized by having one or more halogens with bonds that can be broken either by direct absorption of light or by energy transferred from another absorbing part of the same or

different moleculs. The halogen so liberated participates in performing desired chemistry, usually by formation of the acid. Examples of these compounds are 1,1-Bis (4-chlorophenyl)-2,2,2-trichloroethane ("DDT"), tris (2,3-dibromopropyl) isocyanurate ("TBI"), tetrabromocyclohexadieneone, carbon tetraiodine, 2,3,5,triiodobenzoic acid, and diiodosalicylic acid.

Polymers for use in accordance with the present invention have been prepared at varying levels of silicon derivitization and with parent polymers having varying molecular weights. The structural unit of such polymers is shown below:

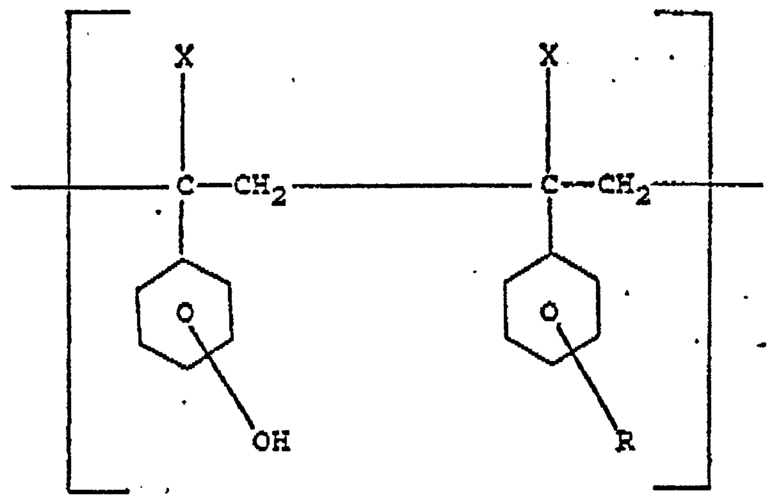

wherein X is H or $CH_3$; R is OH or

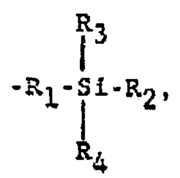

wherein $R_1$ is -O or $-C-(CH_2)_n$, n is 1 to 4, and $R_2$, $R_3$ and $R_4$ are independently selected from 1-4 carbon alkyl, aryl or benzyl. These polymers are more fully described in co-pending United States Patent Application Serial No. 948, 307.

In some photoresist compositions according to this invention, it may be desirable to admix a second sensitizer with the photoresist composition and in other embodiments to incorporate a second sensitize directly into the structure of the polymer itself. In such cases R is further selected from an aromatic azide or the group of esters and amides of o-quinone diazide sulfonic or carboxylic acids.

In yet other embodiments of photoresists according to the present invention, the silylated poly(vinyl)-phenol polymers may be blended with other polymers such as a poly(vinyl)phenol polymer which has not been silylated or a novolak or with cymel.

Resists according to the present invention can be used in monolayer and multi-layer systems. Such resists are prepared using conventional methodology.

In bilayer resists according to the present invention the patternable overlying layer comprises one or more silylated poly(vinyl)phenol polymers, and at least one acid forming sensitizer, the sensitizer comprising an organic compound which forms an acid upon irradiation, the anion of the acid having an affinity for silicon. The material utilized for the underlying layer in such a bilayer system is not critical and typically includes organic materials such as novolac and polyimide resins, e.g., S1400, a product of Shipley Co., Inc., which is basically a novolac resin with a substituted naphthoquinone diazide solution inhibitor, baked at 200° C. for 1.0 hour, and (2) polyimides such as PMGI, another product of Shipley Co., Inc. The underlying layer material preferably is removable with an oxygen plasma and does not appreciably dissolve in the solvent utilized to form the overlying layer. (See, e.g., Introduction to Modern Lithography, supra, Chapter 5, Mucha, J.A., and, Hess, D. W. and Paulsen, supra, for a description of the removal of materials through plasma techniques.) The thickness of the underlying layer depends on the size of the surface irregularities in the substrate. For typical structures utilized in the formation of semiconductor devices, layer thickness

approximately 1 μm yield an essentially planar surface. However, thicknesses greater that 1 μm, are often used in associated processes such as passivation.

The thickness of the overlying layer in the aforementioned bilayer resists depends on the desired resolution. Generally, the thicker the layer, the poorer the resolution. For resolutions less than 2 μm, layer thicknesses in the range of about 0.3 μm to 1.0 μm are generally utilized. Suitable layer thicknesses for either the underlying or overlying layers are easily obtained by conventional techniques such as by dissolving the material that is to form the layer in an appropriate solvent and spin coating the final layer onto the substrate. (A description of spin coating is found in Photoresist Materials and Processes, W. S. DeForest, page 223, McGraw-Hill, New York, 1975.) The spinning speed utilized in the coating procedure determines the layer thickness and is controlled to yield the desired result. Suitable solvents for formation of liquid photoresist compositions include alcohols, ketones, ethers, amides such as dimethyl formamide, esters such as Cellosolve esters and glycol esters, glycol ethers, and other solvents and mixture known in the art.

The optimum molecular weight of the silylated polymers utilized to make resists according to the present invention and the percent by weight silicon content thereof will vary depending upon the desired application. Control samples are easily utilized to determine the optimum molecular weight and average percent silicon of the polymer for a particular application. The silicon content of the polymer influences the etch rate. Both the silicon content and the average molecular weight of the resulting polymer influences lithographic behavior. For example, dissolution rate ratio,$\Psi_R$, changes with molecular weight and percent silicon, and is considered in selecting the desired polymer. Typically, molecular weights in the range of from about 2,700 to 22,000, with the average percent by weight of silicon ranging from about 3% to 12% are desirable. A preferred molecular weight range is from about 2,700 to 7,000, with average % by weight silicon from about 5 to 11%. A particularly preferred polymer for use in bilevel resists formed in accordance with the present invention averages about 10% by weight silicon.

In some cases resists with improved lithography are obtained by blending silylated poly(vinyl)phenol polymers for use according to the present invention with one another. As will be appreciated by those skilled in the art, in some instances other polymers such as unsilylated poly(vinyl)phenol polymers and novolak may be blended with the silylated poly(vinyl)phenol polymers for use according to the present invention.

Sensitizers which form an acid upon irradiation are used in formulating photoresist compositions according to the present invention. The anion of such an acid has an affinity for silicon. Wherein the acids are halogen acids, the anions have an affinity for silicon in the decreasing order as follows: $F^- > Cl^- > CN^- > Br^- > I^-$. The acid released upon exposure causes the exposed region of the silylated poly(vinyl)phenols of the present invention to undergo a change in properties, most importantly solubility due to hydrolysis of oxygen-silicon bonds.

Sensitizers which form an acid upon irradiation are known to those skilled in the art. Such sensitizers will form an acid in response to radiation of differing wavelengths ranging from visible to x-ray. Thus, the sensitizer chosen will depend, in part, upon the wavelength of the radiation to be used for exposure. By selecting the appropriate sensitizer, the photoresists can be imaged by deep u.v., e-beam, laser or any other activating energy conventionally used for imaging photoresists.

In some embodiments, photoresist compositions according to the present invention further comprise a second sensitizer. Conventional photoactive compounds (PACs) well known to those skilled in the art such as, substituted diazonopthoquinones (positive resist), are used as the second sensitizer. Such PACs may be blended with the photoresist compositions or may be incorporated into the structure of the silylated poly-(vinyl)phenol polymer itself, or the structure of the parent poly(vinyl)phenol polymer.

In yet other embodiments of the present invention, water is added to the photoresist composition. Water in a concentration of from about 5% to 8% by weight has been found to improve the photospeed of such compositions.

Exposed photoresist compositions of the present invention may be developed with conventional aqueous alkali solvents to yield positive images or with conventional organic solvents to yield negative images. A negative image may also by formed in accordance with the present invention by admixing a cross-linking agent such a cymel ("melamine") with the photoresist compositions. A latent image is formed on the photoresist composition by exposure to radiation. The photoresist composition is then heated to cross-link the exposed area through the action of cymel. The entire wafer is then flood exposed, thereby rendering the previously unexposed regions soluble in alkali. Development would leave the pattern defined by the first exposure as a negative tone image.

Photoresist compositions, according to the present invention, offer clear advantages over known photoresists. In the present invention, non-metallic acid precurers are used and no dopant species are

involved at all. This fact also provides greater potential for dry development using plasma development. Photoresist compositions provided by the present invention may be exposed with e-beam, x-ray, as well as ultra-violet light.

The present invention also offers advantages over other deep u.v. systems in use at the present time. For example, the present invention provides positive acting, deep u.v. photoresists using aqueous development. Photoresist compositions of the present invention can be used to make monolevel or bilevel resists, and it provides potential for dry development without extra steps. A photogenerated halogen acid reacts with silicon and forms initially, e.g., trialkylsilylhalides. These species are volatile and also are closer in properties to the tetrahalosilanes generated upon plasma etching of silicon than are the oxygen-silicon moieties in the unexposed regions. Under appropriate exposed plasma etch conditions and gases easily determined by those skilled in the art, this difference, between exposed and unexposed areas may be exploited, with one being potentially etched (dry-developed) over the other.

In photoresist compositions according to the present invention which have been exposed to radiation, the exposed area is hydrophilic, whereas the unexposed area is hydrophobic. A negative tone image can be achieved by developing the unexposed photoresist, which is hydrophobic in nature, with an organic solvent which dissolves the hydrophobic area and leaves the hydrophilic area intact.

Examples of aqueous alkali developers are those based on tetramethylammonium hydroxide or sodium hydroxide and an example of an organic based developer is 60/40 isopropanol/water. Typical acid release sensitizers include TBI, DDT, 3,5 diiodosalicylic acid, tetrabromocylohexadienone, carbon tetraiodine and 2,3,5-triiodobenzoic acid.

Other additives that may be included in the silylated poly(vinyl)phenol polymers used to form resists according to the present invention include leveling agents, adhesion promoters, cross-linking agents such as cymels ("melamine") and so forth, all known to those skilled in the art.

The glass transition temperature (Tg) of the silylated poly(vinyl)phenol polymers of the present invention is generally higher than 60°C, usually from about 64-100°C.

The poly(vinyl)phenol polymers used to form resists in accordance with the present invention are derivatized with organosilicon moieties by conventional techniques. Such derivatization may be accomplished by use or organosilicon compounds known to those skilled in the art capable of transferring a trisubstituted silylmethyl group such as trimethylsilylmethylchloride, bromide, mesylate or tosylate. Such derivatization may also be accomplished by use of trisubstituted silylating reagents known to those skilled in the art, such as hexamethyldisilazane, trimethylchloride, bromide, cyanide or mesylate; or O,N′-bis-trimethylsilylacetamide; or phenyldimethylsilylchloride or t-butyldimethylsilyl chloride.

One preparation in accordance with the present invention involves dissolving a PVP4100TMS60 resin and tris (2,3dibromopropyl) isocyanurate into a propyleneglycol monomethylether acetate in the ratios of 1:0.25:46 by weight. Another preparation preferred for dry-development processes utilizes the same resin and solvent but has the compound DDT as an acid generator. In this case the respectrive ratios of 1:0.40:4 are used.

To process the inventive positive bilevel resists, the overlying silylated polymer layer is exposed with suitable radiation, such as ultraviolet radiation. The wavelength range 220 nm to 436 nm is generally utilized. Typically, incident exposure doses in the range 0.05 joule/cm$^2$ to 1.0 joule/cm$^2$ are employed. The specific exposure dose employed should be sufficient to cause a chemical reaction from the surface of the region that is subjected to radiation, through the volume underlying the exposed surface region, to the underlying resist material. Thus, the exposure should be sufficient so that upon development, the underlying resist material in the exposed regions is uncovered.

In some processes according to the present invention, a water wash or dip step after exposure and before development is desirable because it has been found to improve the photospeed of the inventive resists disclosed herein.

Development of positive resists according to the present invention was accomplished through the use of aqueous alkali solutions well known in the resist art. After the overlying layer was developed, its pattern was transferred to the underlying layer by subjecting the substrate to an oxygen plasma using techniques known to those skilled in the art.

After the pattern has been transferred to the underlying layer, the delineated bilevel resist is utilized for processing steps such as metallization, dopant diffusion, or etching of the substrate. The resist is then removed either by lift-off technique (See, e.g., Integrated Circuit Fabrication Technology, Elliot, D.J., p. 32, McGraw Hill, New York, N.Y., 1982) or an oxygen/fluorocarbon plasma, and the processing of the substrate is completed to form the desired electronic devices.

In the semiconductor and hybrid circuit industries, passivation coatings are used in selected areas for serving as a hermetic seal.

Requirements for this use are high temperature capability with image stability and good dielectric properties. The resists of this invention are suitable for such applications, especially after conversion to oxide in an oxygen plasma.

Photoresists according to the present invention can also be used as a monolevel photoresist over metal. The pattern is developed in a conventional manner. Then the wafer is exposed briefly to an oxygen plasma. The resulting silicon dioxide lines will stand up better to the subsequent metal plasma etching than would conventional photoresist. For example, photoresist compositions according to the present invention can be used as a patternable oxide layer for subsequent etching over aluminum. Conventional resists etch about 1.5 times more slowly than aluminum. However, by exposing a photoresist composition according to the present invention briefly to an oxygen plasma, a silicon dioxide crust is generated which behaves more like thermal oxide than as an organic resist. Thermal silicon dioxide etches about 20 times slower than aluminum. Therefore, using resists according to the present invention improves the etch selectivity of aluminum over that of conventional photoresists. A similar methodology can be used to produce an ion-implant mask rather than a plasma etch barrier. It is also possible to simply spin on the resist material with or without photosensitizer, and then, without patterning, expose it to an oxygen plasma. This method easily creates an oxide dielectric layer, something which usually requires expensive equipment.

The following examples are illustrative of the invention.

As used hereinafter:

PVP followed by a number represents the molecular weight of the parent PVP polymer before derivitization with silicon.

TMS followed by a number represents the percent derivitization with silicon achieved.

Percent by weight silicon is based on the molecular weight of the silicon derivitized PVP polymer.

PAC represents substituted 2,1,5-diazonaphthoquinone PAC.

TMAH means tetra-methyl ammonium hydroxide.

MF312-CD27 means a 0.27N TMAH based developer available from Shipley Company.

MF312 means a 0.54N TMAH based developer available from Shipley Company.

TBI means tris(2,3dibromopropyl)isocyanurate.

DDT means 1,1-bis(4-chlorophenyl)-2,2,2-trichloroethane.

## EXAMPLE 1

### Preparation of Polymers

#### A. O-Trimethylsilylpoly(vinyl)phenol

In a 3-neck flask a solution was prepared by the addition of 200gm of vacuum oven dried poly(vinyl)-phenol (Maruzen Co., MW4100, dispersity 2.2) to 1250 ml dioxane at 85°C with stirring. After dissolution was complete, a total of 20 ml triethylamine (Aldrich Chemical Co., dried by distillation from BaO) was added followed by dropwise addition of 80ml (0.5aq) hexamethyldisilazane over 15 minutes (Aldrich Chemical Co.) to prepare a 60% derivatized polymer.

The reaction was kept at 85°C under an atmosphere of nitrogen for 48 hours. The apparatus was arranged for distillation and heating was increased until solvent began to distill (approximately 140°). When most of the solvent was gone the material was transferred to another flask and dried further by rotary evaporation. Final drying in a vacuum oven (120°C) gave a brittle solid with 60% of the hydroxyl sites derivatized as determined by NMR.

#### B. O-Methyltrimethylsilylpoly(vinyl)phenol

In a round bottom flask a solution of 48.7gm (.42m) methylacetoacetate in 300ml dioxane was prepared. This solution was cooled with an ice bath and a suspension of 10.1gm (.42) sodium hydride (Alfa) in 100 ml dioxane was dropped slowly in over 1 hour.

The resulting light brown suspension was then dropped slowly into a rapidly stirred solution of 168.0g poly(vinyl)phenol (Maruzen Co., MW7000, dispersity 2.2) and 58.3 ml (0.42m) chloromethyltrimethylsilane (Petrarch Co.) in 1300 ml DMF at 90°C. The solution was reacted overnight at 90°C.

Solvent was distilled off at atmosphere pressure until approximately 400 ml of material remained. It was allowed to cool about 70°C and 500 ml of methylethylketone was added. The resulting solution was washed

thoroughly with water and the organic fraction dried over magnesium sulfate.

After filtration and removal of solvent by rotary evaporation, the material was dried in a vacuum oven at 120°C for one day. Analysis by NMR showed 25% of the hydroxy sites had been reacted. The Tg of the material was 91°C.

EXAMPLE 2

PHOTORESIST --PVP4100TMS60, TBI SENSITIZER

A solution of 10gm PVP4100TMS60 0.2 gm TBI and 40.8 gm propylene glycol monomethyl ether acetate (DOWANOL PMA) was made and then passed through a 0.3μ filter. This material was spin coated onto a wafer which had already been covered with 1.0 micron of S1400 (a novolak based resist) and baked at 200°C. for one hour. This bilevel wafer was soft-baked for 30 min. at 90°C. in a convection oven. This gave a 4500 Å thick top level.

The wafer was exposed to a total dose of 170 $mj/cm^2$ at 254nm on an ORIEL broad band hard contact printer. Immersion in a 0.54 N TMAH based developer for 50 sec. resolved 0.75 micron line/space patterns which were the limit of the mask used and were 2500 Å thick.

This bilevel system was etched in a Plasma-Technologies RIE etcher using the following conditions: 32 SCCM $O_2$, 20mT, 100W 25°C, carbon covered bottom electrode and 350V bias. A SEM microphotograph shows lines etched through the bottom layer to the substrate. The sidewalls are perfectly vertical and the spaces are free of "grassing" or debris.

EXAMPLE 3

CONTRAST CURVE PVP4100TMS60 --TBI SENSITIZER

A formulation consisting of 10gm PVP4100TMS60, 0.20 gm TBI and 34 gm DOWANOL PMA® was coated on a silicon wafer and soft-baked at 90°C. for 30 min. in a convection oven.

A quartz OPTOLINE® mask, which has pads of increasing transmission across its surface, was laid on the surface of the wafer. This arrangement was then exposed for 20 sec with an HTG Deep UV light source. Development for 60 sec in 0.70 N sodium hydroxide based developer cleared off several of the more transmissive areas. Measurements of the remaining pads' thicknesses were done using a Nanospec® optical inference instrument. These thicknesses were plotted against the logarithm of the transmitted energy at 254 nm (incident dose was 23 $mw/cm^2$) and resulted in a contrast curve. The initial thickness of 7500Å was maintained until a dose of 65 $mj/cm^2$ had been achieved whereupon the material was thinned to 6450Å. This level was the same until a dose of 200 $mj/cm^2$ was reached. Between 200 and 245 $mj/cm^2$ of exposure energy the resist was cleared away.

These results indicate that the system has high inherent contrast and, after an initial loss of 1000Å, no further unexposed loss.

EXAMPLE 4

The same formulation as used in Example 3 above was coated and soft-baked to 4500Å over 1.0 micron of hard-baked S1400 novolak resist or 5-inch silicon wafers. Wafers were exposed on a Perkin-Elmer model 500 scanner with numerical aperture of 0.17 at 455 $mj/cm^2$ over the 240-260nm wavelength range. Development by immersion in 0.54N TMAH based developer for 105 sec resolved 0.75 micron lines, the smallest on the mask. SEM photographs showed profiles that were vertical and sharp edges.

Several wafers were then subjected to oxygen RIE to transfer the patterns through the bottom layer. The etcher was a Plasma-Technologies brand and the plasma was generated with 32SCCM $O_2$, ROmT pressure, 100 W power, 350 V bias and the bottom carbon covered electrode was held at 25°C by means of water cooling. After etching for 12 min, the wafers were cracked and SEM photographs taken. These showed perfectly vertical sidewalls through both layers, with the top layers' thickness at 2400Å. The substrate was clean and free of "grassing" and debris.

EXAMPLE 5

PHOTORESIST --PVP5100TMS50 AND TBI

A solution was prepared by heating 10gm PVP5100TS50 and 0.35gm TBI in 30gm DOWANOL PMA at 60°C with stirring until all ingredients were dissolved. After cooling and filtering to 0.2 microns the formulation was spin coated onto a bare silicon wafer at 4000 rpm and then soft-baked at 100°C for 50 sec on a hot-plate. The final thickness was 1.0 microns.

This systsem was exposed at 60 mJ/cm² over the 240-260nm range on a Perkin-Elmer 550 Microalign Scanner of NA-0.17, Development was carried out by immersing for 45 sec in 0.54N TMAH based developer. This produced resolved 1.5 micron line/space patterns.

EXAMPLE 6

PHOTOSRESIST --PVP4100TMS60, TBI AND DIIODOSALICYLIC ACID SENSITIZERS

A solution of 10 gm PVP4100TMS60, 0,15 gm TBI, 0.05 gm 3,5 diiodosalicylic acid and 40.8 gm DOWANOL PMA was made. After spin-coating onto a wafer with 1.3 micron hard-baked S1400, it was soft-baked for 30 min. at 90°C. in a convection oven.

The resultant wafer was exposed to 210 mJ/cm² measured at 254 nm. or an ORIEL broad band hard contact printer. It was then developed for 60 sec by immersion in a 0.54N TMAH based developer.

This system resolved 2.0 micron line/space pairs whereas a formulation with 20% TBI and no iodosolicylic acid resolved 1.0 micron lines/space pairs. In neither case was there any significant unexposed loss.

EXAMPLE 7

PHOTORESIST --PVP5100TMS50, TETRABROMOCYCLOHEXADIENONE AND 2,1,5 - DIAZONAPTHOQUINONE

A solution was made consisting 10 gm PVP5100TMS50, .35 gm 2,1,5 diazonaphthoquinone PAC, 0.05 gm tetrabromocyclohexadienone (Lancaster Synthesis Co.) and 35 gm diglyme. This was coated on a silicon wafer and soft-baked at 90°C. for 30 minutes. A control wafer with the above photoresist without the acid generating compound was treated similarly.

Both wafers were analyzed for photospeed by use of a scanning wedge apparatus at 436 nm. Exactly the same exposure conditions followed by 60 sec immersion development in MF312 were used. The wafer with the acid generator had a clear surface that was 30% larger than the control. This is a direct measure of the reduction in energy requirement needed to perform lithography.

EXAMPLE 8

DRY-DEVELOPMENT

A solution consisting of 10 gm PVP4100TMS60 and 0.20 gm DDT in 51 gm DOWANOL PMA was spin coated onto a silicon wafer. After soft-baking for 30 min at 90°C, to a thickness of 5400Å, the wafer was exposed for 60s by an HTG Deep UV unit through a quartz OPTOLINE® mask which had been laid on the wafer.

This wafer was placed into a plasma generated by a DryTek-DRIE100 etcher using 112SCCM $SF_6$, 20 SCCM $O_2$, 500 watts and 197 mT pressure for 7 min. The pads of the mask were cleared to the substrate down to the energy level of 160 mj/cm². From this energy level to 110 mj/cm, the thickness rapidly increased to a relatively constant level of 2500Å. The thicknesses were measured by scratching a line to the substrate and determining its depth using a DekTak® profilometer.

EXAMPLE 9

WATER DIP AFTER EXPOSURE AND BEFORE DEVELOPMENT (MONOLEVEL MODE)

A formulation was made by heating a mixture of 10 gm PVP4100TMS60 and 0.35 gm TBI in 30 gm DOWANOL PMA at 50°C with stirring until all ingredients were dissolved. This was allowed to cool and then passed through a 0.3μ filter. Spin coating was performed at 4000 rpm onto bare silicon wafers and then baked on a 130°C hotplate for 50 sec. This gave a monolevel thickness of 1.0μ.

These wafers were exposed on a Perkin-Elmer 550 Microalign Scanner with numerical aperture of 0.17 at 240-260nm wavelength for a total dose of 60 mJ/cm².

One wafer was dipped in a wter bath for 2 min and developed for 30 sec in 0.54 N TMAH based developer. This process resolved 1.25μ line/space patterns as seen by SEM photographs. In comparison, a wafer which was not exposed to water but developed for a longer time, i.e., 60 sec in the same developer, resolved 1.5μ patterns.

It is understood that the examples and embodiments described herein are for illustrative purposes only and that various modifications or changes in light thereof that will be suggested to persons skilled in the art are to be included in the spirit and purview of this application and the scope of the approved claims.

## Claims

1. A photoresist composition comprising an admixture of a silylated polymer and at least one acid forming sensitizer, the sensitizer comprising a non-metallic organic compound which forms an acid upon irradiation, wherein the anion of the acid has an affinity for silicon, the polymer containing the structural unit

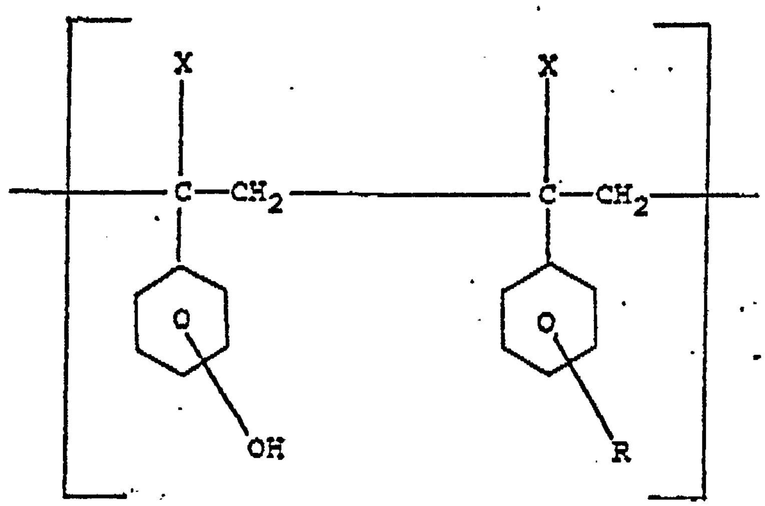

wherein X is H or $CH_3$; R is OH or

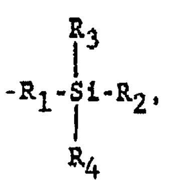

wherein $R_1$ is O or $O(CH_2)_n$, n is 1 to 4, and $R_2$, $R_3$ and $R_4$ are independently selected from 1-4 carbon alkyl, aryl or benzyl.

2. A photoresist composition according to claim 1, wherein the acid forming sensitizer forms a halogen acid or hydrogen cyanide upon irradiation.

3. A photoresist composition according to claim 1 further comprising water at from about 5% to 8% by weight.

4. A photoresist composition according to claim 1 wherein the acid forming sensitizer is TBI, DDT, tetrabromocyclohexadieneone, carbontetraiodine, 2,3,5-triiodobenzoic acid or diiodosalicylic acid.

5. A photoresist composition according to claim 1 further comprising a second sensitizer.

6. A photoresist composition according to claim 5 wherein the second sensitizer is selected from the group of esters and amides of o-quinone diazide sulfonic or carboxylic acids.

7. A photoresist composition according to claim 6, wherein at least some of the second sensitizer is incorporated into the structure of the silylated polymer and R is further selected from the group of esters and amides of o-quinone diazide sulfonic or carboxylic acids.

8. A photoresist composition according to claim 1 wherein the molecular weight is from about 2,700 to 22,000 and the average percent by weight silicon is from about 3% to 12%.

9. A photoresist composition according to claim 8 wherein the average percent by weight silicon is attained by blending two or more silylated polymers.

10. A photoresist composition according to claim 1 wherein X is H, $R_1$ is O, $R_2$, $R_3$ and $R_4$ are $CH_3$.

11. A photoresist composition according to claim 1 wherein X is H, $R_1$ is $OCH_2$, $R_2$, $R_3$ and $R_4$ are $CH_3$.

12. A photoresist composition according to claim 1 further comprising an admixture of a poly(vinyl)-phenol polymer or a novolak.

13. A photoresist composition according to claim 1 further comprising an admixture of a cymel.

14. A process for fabricating a device comprising the steps of:

(a) forming a photoresist composition on a substrate, the photoresist composition comprising an admixture of a silylated polymer and at least one acid forming sensitizer, the sensitizer comprising a non-metallic compound which releases an acid upon irradiation, the anion of the acid having an affinity for silicon, the polymer containing the structural unit

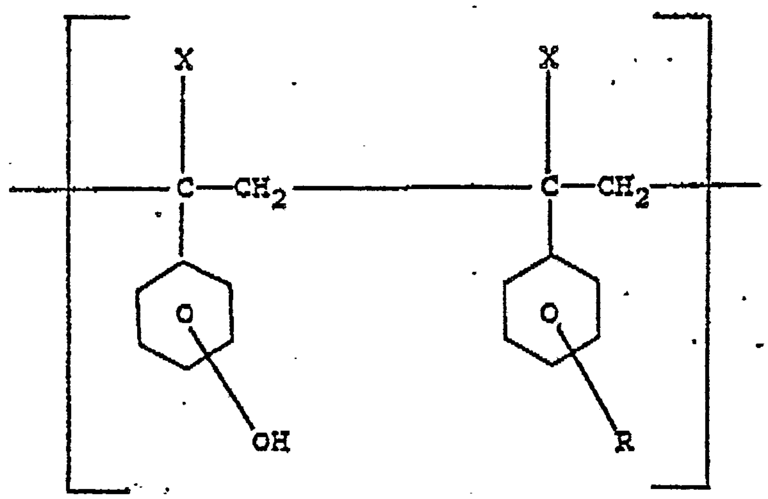

wherein X is H or $CH_3$; R is OH, or

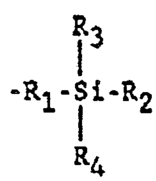

wherein $R_1$ is O or $O(CH_2)_n$, n is 1 to 4, and $R_2$, $R_3$ $R_4$ are independently selected from 1-4 carbon alkyl, aryl or benzyl, the molecular weight is from about 2,700 to 22,000 and the average percent by weight silicon is from about 3% to 12%;

(b) exposing at least a portion of said photoresist composition to radiation, and

(c) further processing said substrate.

15. The process of claim 14 further comprising a water wash between steps (a) and (c).

16. The process of claim 14, wherein the silylated polymer is formed by silylating a poly(vinyl)phenol polymer.

17. The process of claim 14, wherein the photoresist composition is exposed in a predetermined pattern.

18. The process of claim 17, wherein the exposed photoresist composition is subjected to plasma discharge.

19. The process of claim 14, wherein the sensitizer is TBI, DDT, tetrabromocyclohexadieneone, carbontetraiodine, 3,3,5-triiodobenzoic acid or diiodosalicylic acid.

20. The process of claim 14, wherein the photoresist composition further comprises a second sensitizer,

21. The process of claim 20, wherein the second sensitizer is selected from the group of esters and amides of o-quinone diazide sulfonic or carboxylic acids.

22. The process of claim 21, wherein the sensitizer is an ester of an o-naphthoquinone diazide sulfonic acid chloride.

23. The process of claim 14, wherein a region capable of selective removal is interposed between said photoresist composition and said substrate and the photoresist composition is exposed in a predetermined pattern.

24. The process of claim 23, wherein the exposed portion of the photoresist compositions is developed by means of a solvent and the region capable of selective removal is removed by being subjected to a plasma discharge.

25. The process of claim 24, wherein said plasma discharge comprises an oxygen plasma discharge.

26. The process of claim 23, wherein the exposed region is developed by means of a first solvent and the region capable of selective removal is removed by being subjected to a second solvent.

27. The process of claim 14, wherein the device is baked after exposure to radiation.

28. The process of claim 14, wherein the substrate comprises a metal and further processing comprises exposing the photoresist composition briefly to an oxygen plasma and subsequently etching the metal substrate.

29. The process of claim 28, wherein the metal substrate comprises aluminum.

30. The process of claim 14, wherein the photoresist composition is subjected to an oxygen plasma to form a silicon oxide dielectric layer.